Europäisches Patentamt

European Patent Office

Office européen des brevets

(11) Numéro de publication: **0 387 741**

**A1**

## (12) DEMANDE DE BREVET EUROPEEN

(21) Numéro de dépôt: **90104614.4**

(22) Date de dépôt: **12.03.90**

(51) Int. Cl.⁵: **B23K 26/08, B23Q 35/128**

(30) Priorité: **16.03.89 FR 8903477**

(43) Date de publication de la demande:
**19.09.90 Bulletin 90/38**

(84) Etats contractants désignés:
**BE CH DE ES FR GB IT LI NL SE**

(71) Demandeur: **COMPAGNIE GENERALE D'ELECTRICITE Société anonyme dite:**
**54, rue La Boétie**
**F-75382 Paris Cédex 08(FR)**

(72) Inventeur: **Beaupere, Didier**
**4, Cité Joyeux**
**F-75017 Paris(FR)**

(74) Mandataire: **Weinmiller, Jürgen et al**
**Lennéstrasse 9 Postfach 24**
**D-8133 Feldafing(DE)**

(54) **Procédé et dispositif d'usinage d'une pièce à l'aide d'un faisceau laser.**

(57) La présente invention concerne l'usinage d'une pièce (65) par un faisceau laser, notamment ultraviolet, convenablement focalisé (75) par une lentille de travail (5).

Les déplacements de cette lentille accompagnent en balayage et en profondeur ceux d'une autre lentille (6) intégrée dans un palpeur optique (46, 6, 20, 14, 15, 16, 12, 7, 8, 9, 10, 18) qui suit une surface de modèle (28) formée sur une autre pièce.

L'invention s'applique notamment à la réalisation de pièces céramiques.

## Procédé et dispositif d'usinage d'une pièce à l'aide d'un faisceau laser

La présente invention concerne l'usinage d'une pièce, notamment d'une pièce constituée au moins partiellement d'un matériau céramique, telle qu'un substrat pour circuit électronique, une prothèse dentaire, etc...

Un dispositif connu pour effectuer un usinage de pièces comporte certains éléments qui lui sont communs, du moins quant à leurs fonctions indiquées ci-après, avec un dispositif selon l'invention. Ces éléments communs sont :

- Un générateur laser pour former un faisceau de travail non focalisé,
- un moyen de focalisation de travail pour recevoir ce faisceau de travail non focalisé et en former un faisceau de travail focalisé en un foyer de travail sur une face de travail d'une pièce à usiner,
- des moyens de réglage de profondeur de travail commandables pour appliquer audit foyer de travail des déplacements en profondeur selon une direction de profondeur de travail par rapport à ladite pièce à usiner de manière à enlever de la matière à cette pièce sur une profondeur de travail commandée, des directions transversales à cette direction de profondeur de travail constituant des directions transversales de travail,
- des moyens de balayage de travail pour appliquer audit foyer de travail des déplacement, de balayage selon au moins une dite direction transversale de travail par rapport à ladite pièce à usiner,
- et des moyens de suivi de surface pour commander au moins lesdits moyens de réglage de profondeur de travail de manière à rendre ladite face de travail conforme à une surface prédéterminée.

Ce dispositif connu n'atteint qu'imparfaitement les buts de la présente invention, qui sont, notamment,
- de permettre un usinage précis et fin, notamment dans des pièces de haute dureté constituées par exemple en tout ou partie d'un matériau céramique,
- de permettre de réaliser un tel usinage rapidement et facilement,
- et/ou de réaliser un dispositif simple, peu coûteux et de maintenance facile pour effectuer un tel usinage.

La présente invention a notamment pour objet un procédé d'usinage d'une pièce à l'aide d'un faisceau laser, procédé dans lequel on focalise un faisceau laser de travail sur une face d'une pièce à usiner, on déplace le point de focalisation de ce faisceau par rapport à cette pièce pour former sur cette pièce une surface en relief, on focalise en outre un faisceau laser de pilotage sur une surface de modèle, on déplace le point de focalisation de ce faisceau de pilotage sur cette surface de modèle, et on déplace le point de focalisation dudit faisceau de travail sur ladite pièce à usiner en suivant les déplacements du point de focalisation dudit faisceau de pilotage sur ladite surface de modèle, ce procédé étant caractérisé par le fait qu'on détecte la largeur d'une tache de pilotage formée par ledit faisceau de pilotage sur ladite surface de modèle, on applique des déplacements de profondeur au point de focalisation de ce faisceau selon la direction de ce faisceau de manière à limiter la largeur de cette tache pour maintenir ce point de focalisation sur cette surface même quand elle présente des reliefs, et on applique au point de focalisation dudit faisceau de travail des déplacements de profondeur suivant ceux du point de focalisation dudit faisceau de pilotage pour former sur ladite pièce à usiner une surface dont le relief suit celui de ladite surface de modèle.

Dans un dispositif selon la présente invention comportant les éléments communs précédemment indiqués, on peut adopter certaines au moins des dispositions préférées suivantes :
- Lesdits moyens de suivi de surface comportent
- un générateur laser pour former un faisceau de pilotage non focalisé,
- des moyens de focalisation de pilotage pour recevoir ce faisceau de pilotage non focalisé et en former un faisceau de pilotage focalisé en un foyer de pilotage situé sensiblement sur une surface de modèle présentée par une pièce de modèle et conforme à ladite surface prédéterminée, de sorte que ce faisceau forme sur cette surface de modèle une tache lumineuse qui présente certaine une largeur et qui constitue une tache de pilotage,
- des moyens de réglage de profondeur de pilotage commandables pour appliquer audit foyer de pilotage des déplacements de profondeur selon une direction de profondeur de pilotage par rapport à ladite pièce de modèle en faisant varier la largeur de ladite tache de pilotage, des directions transversales à ladite direction de profondeur de pilotage constituant des directions transversales de pilotage,
- des moyens de balayage de pilotage pour appliquer audit foyer de pilotage des déplacements de balayage selon au moins une dite direction transversale de pilotage par rapport à ladite pièce de modèle, ces déplacements de balayage reproduisant lesdits déplacements de balayage dudit foyer de travail,
- des moyens de formation d'une image de ladite tache de pilotage,
- un détecteur de pilotage recevant cette image pour être sensible à la largeur de ladite tache de pilotage,

- et un circuit d'asservissement commandé par ledit détecteur de pilotage et commandant lesdits moyens de réglage de profondeur de pilotage pour maintenir petite la largeur de ladite tache de pilotage, grâce à quoi ledit foyer de pilotage est maintenu au contact de ladite surface de modèle lors desdits déplacements de balayage,

- ledit circuit d'asservissement commandant aussi lesdits moyens de réglage de profondeur de travail de manière que lesdits déplacements de profondeur dudit foyer de travail reproduisent ceux dudit foyer de pilotage.

- Un seul dit générateur laser forme un faisceau initial dont une fraction majoritaire forme ledit faisceau de travail non focalisé et dont une fraction minoritaire forme ledit faisceau de pilotage non focalisé.

- Lesdites directions de profondeur de travail et de pilotage sont une même direction de profondeur et lesdits moyens de balayage appliquent les mêmes déplacement de balayage auxdites pièces de travail et de modèle.

- Lesdits moyens de balayage portent les deux dites pièces à usiner et de modèle sur une même platine porte pièces.

- Lesdits faisceaux de travail et de pilotage non focalisés sont des faisceaux parallèles et sont parallèles à ladite direction de profondeur,

- lesdits moyens de focalisation de travail et de pilotage étant des lentilles de travail et de pilotage,

- lesdits moyens de réglage de profondeur de travail et de pilotage étant des moyens pour déplacer lesdites lentilles de travail et de pilotage, respectivement, selon ladite direction de profondeur.

- Les axes desdites lentilles sont confondus avec ceux desdits faisceaux de travail et de pilotage, respectivement.

- Lesdits moyens de réglage de profondeur de travail et de pilotage sont des moyens de réglage de profondeur portant lesdites lentilles de travail et de pilotage sur une ou deux pièces porte lentilles et déplaçant ces pièces selon ladite direction de profondeur.

- Le dispositif comporte des moyens de commande de vitesse pour faire varier la vitesse desdits déplacements de balayage en fonction de paramètres de travail tels que ladite profondeur de travail, des caractéristiques du matériau constituant ladite pièce à usiner, et la puissance desdits faisceaux de travail.

- Un calculateur constitue au moins partiellement ledit circuit d'asservissement et lesdits moyens de commande de vitesse.

- Lesdits faisceaux de travail sont constitués d'une lumière ultraviolette qui est par exemple fournie par un laser à excimère

- Ce dispositif est utilisé dans le cas où ladite face de travail de ladite pièce à usiner est constituée d'un matériau céramique.

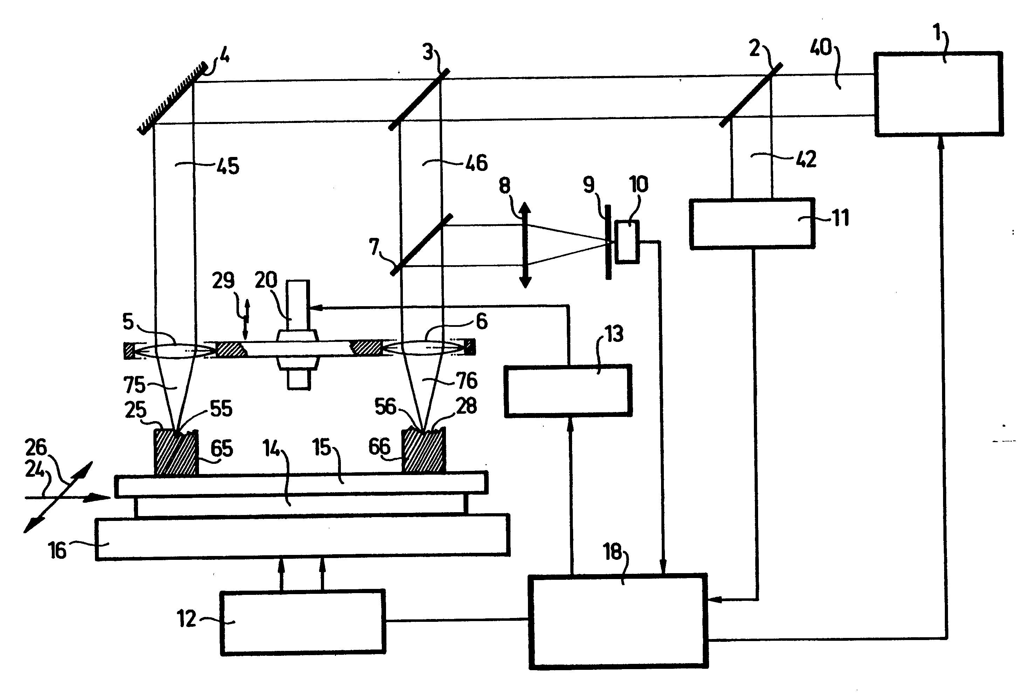

A l'aide de la figure schématique ci-jointe, on va décrire ci-après comment la présente invention peut être mise en oeuvre, étant entendu que les éléments et dispositions mentionnés et représentés ne le sont qu'à titre d'exemples non limitatifs.

Cette figure unique représente un schéma d'un dispositif selon l'invention qui comporte les dispositions préférées décrites ci-dessus. En ce qui concerne les éléments qui ont été mentionnés à propos de ces dispositions, les signes de référence qui les désignent vont être d'abord indiqués ci-après :

- Générateur laser 1. Ce générateur est un laser à excimère fournissant un faisceau initial 40 ayant une puissance moyenne de 1W avec une durée d'impulsion de 40 ns, une fréquence de récurrence de 40 Hz, et une longueur d'ondes de 308 nm.

- Faisceau de travail non focalisé 45. Son diamètre est de 10 mm.

- Lentille de travail 5. Elle est constituée de silice avec un diamètre de 50 mm et une distance focale de 75 mm pour former le faisceau de travail focalisé 75 qui converge au foyer de travail 55.

- Face de travail 25 sur la pièce à usiner 65.

- Moyens de réglage de profondeur 20 comportant une pièce porte lentilles unique 21 qui se déplace selon la direction de profondeur 22.

- Moyens de balayage comportant une base 16, une platine intermédiaire lu se déplaçant selon la direction transversale 26 et une platine porte pièces 15 permettant en outre un déplacement selon l'autre direction transversale 24.

- Faisceau de pilotage non focalisé 46 ayant le même diamètre que le faisceau de travail non focalisé 45 mais une puissance beaucoup plus faible par exemple 10 mW.

- Lentille de pilotage 6. Elle est identique à la lentille de travail 5 et solidaire de celle-ci, pour former le faisceau de pilotage focalisé 76. Ce dernier converge au foyer de pilotage 56 sur la surface de modèle 28 présentée par la pièce de modèle 66.

- Les moyens de formation d'une image de la tache lumineuse de pilotage comportent la lentille de pilotage 6 à travers laquelle passe la lumière renvoyée par cette tache, une lame séparatrice 7 traversée par le faisceau de pilotage non focalisé, et une lentille 8 recevant la fraction de la lumière renvoyée qui a été séparée par la lame 7, et formant une image de la tache de pilotage.

- Le détecteur de pilotage comporte de manière connue un diaphragme 9 disposé dans le plan de l'image de la tache de pilotage, et une diode photosensible 10 placée derrière l'ouverture de ce diaphragme. Le diamètre de cette ouverture et sa position correspondent sensiblement à ceux de cette image lorsque la tache de pilotage a une largeur minimale qui est atteinte lorsque le foyer de pilotage est situé exactement sur la surface de modèle 28, de sorte que la quantite de lumière reçue par la photodiode 10 est alors maximale, et qu'elle diminue lorsque la tache de pilotage s'élargit parce que le foyer de pilotage s'éloigne dans une direction ou dans l'autre de la surface de modèle 28.

- Le calculateur 18 reçoit le signal de sortie de la photodiode 10. Il commande les déplacements de profondeur et de balayage par l'intermédiaire d'actionneurs 13 et 12, respectivement. On constitue ainsi un palpeur optique d'un type connu en soi pour suivre les variations d'une profondeur d'une surface telle que 28 soumise par ailleurs à des déplacements de balayage.

Conformément à la figure, le faisceau initial 40 formé par le laser 1 traverse une première lame séparatrice 2 qui en sépare un faisceau de mesure 42 de très faible puissance. Ce faisceau de mesure est reçu par un dispositif de mesure 11 dont le signal de sortie est reçu par le calculateur 18. Ce signal permet à ce calculateur :

- de rapporter l'énergie reçue par la diode photosensible 10 à l'énergie de l'impulsion fournie par le laser 1, de manière que la variation éventuelle d'énergie entre impulsions successives ne fausse pas l'asservissement réalisé par le palpeur optique.

- de commander le laser 1 pour lui faire fournir des impulsions appropriées,

- et de commander la vitesse des déplacements de balayage.

Le faisceau initial 40 traverse ensuite une deuxième lame séparatrice 3 qui forme le faisceau de pilotage non focalisé 46. Il rencontre enfin un miroir 4 qui forme le faisceau de travail non focalisé 45.

## Revendications

1/ Procédé d'usinage d'une pièce à l'aide d'un faisceau laser, procédé dans lequel on focalise un faisceau laser de travail sur une face d'une pièce à usiner, on déplace le point de focalisation de ce faisceau par rapport à cette pièce pour former sur cette pièce une surface en reflief, on focalise en outre un faisceau laser de pilotage sur une surface de modèle, on déplace le point de focalisation de ce faisceau de pilotage sur cette surface de modèle, et on déplace le point de focalisation dudit faisceau de travail sur ladite pièce à usiner en suivant les déplacements du point de focalisation dudit faisceau de pilotage sur ladite surface de modèle, ce procédé étant caractérisé par le fait qu'on détecte la largeur d'une tache de pilotage formée par ledit faisceau de pilotage sur ladite surface de modèle, on applique des déplacements de profondeur au point de focalisation de ce faisceau selon la direction de ce faisceau de manière à limiter la largeur de cette tache pour maintenir ce point de focalisation sur cette surface même quand elle présente des reliefs, et on applique au point de focalisation dudit faisceau de travail des déplacements de profondeur suivant ceux du point de focalisation dudit faisceau de pilotage pour former sur ladite pièce à usiner une surface dont le relief suit celui de ladite surface de modèle.

2/ Dispositif d'usinage d'une pièce à l'aide d'un faisceau laser, ce dispositif comportant :

- un générateur laser (1) pour former un faisceau de travail non focalisé (45),

- un moyen de focalisation de travail (5) pour recevoir ce faisceau de travail non focalisé et en former un faisceau de travail focalisé en un foyer de travail (55) sur une face de travail (25) d'une pièce à usiner (65),

- des moyens de réglage de profondeur de travail (20) commandables pour appliquer audit foyer de travail des déplacements en profondeur selon une direction de profondeur de travail par rapport à ladite pièce à usiner de manière à enlever de la matière à cette pièce sur une profondeur de travail commandée, des directions transversales à cette direction de profondeur de travail constituant des directions transversales de travail,

- des moyens de balayage de travail (14, 15, 16) pour appliquer audit foyer de travail des déplacements de balayage selon au moins une dite direction transversale de travail (24) par rapport à ladite pièce à usiner,

- et des moyens de suivi de surface pour commander au moins lesdits moyens de réglage de profondeur de travail de manière à rendre ladite face de travail conforme à une surface prédéterminée (28), ce dispositif étant caractérisé par le fait que lesdits moyens de suivi de surface comportent :

- un générateur laser (1) pour former un faisceau de pilotage non focalisé (46),

- des moyens de focalisation de pilotage (6) pour recevoir ce faisceau de pilotage non focalisé et en former un faisceau de pilotage focalisé en un foyer de pilotage (56) situé sensiblement sur une surface de modèle (28) présentée par une pièce de modèle (66) et conforme à ladite surface prédéterminée, de sorte que ce faisceau forme sur cette surface de modèle une tache lumineuse qui présente une certaine largeur et qui constitue une tache de pilotage,

- des moyens de réglage de profondeur de pilotage (20) commandables pour appliquer audit foyer de pilotage des déplacements de profondeur selon une direction de profondeur de pilotage par rapport à ladite pièce de modèle en faisant varier la largeur de ladite tache de pilotage, des directions transversales à ladite direction de profondeur de pilotage constituant des directions transversales de pilotage,

- des moyens de balayage de pilotage (14, 15, 16) pour appliquer audit foyer de pilotage des déplacements de balayage selon au moins une dite direction transversale de pilotage (24) par rapport à ladite pièce de modèle, ces déplacements de balayage reproduisant lesdits déplacements de balayage dudit foyer de travail,

- des moyens (6, 7, 8) de formation d'une image de ladite tache de pilotage,

- un détecteur de pilotage (9, 10) recevant cette image pour être sensible à la largeur de ladite tache de pilotage,

- et un circuit d'asservissement (18) commandé par ledit détecteur de pilotage et commandant lesdits moyens de réglage de profondeur de pilotage (20) pour maintenir petite la largeur de ladite tache de pilotage, grâce à quoi ledit foyer de pilotage est maintenu au contact de ladite surface de modèle lors desdits déplacements de balayage,

- ledit circuit d'asservissement commandant aussi lesdits moyens de réglage de profondeur de travail de manière que lesdits déplacements de profondeur dudit foyer de travail reproduisent ceux dudit foyer de pilotage.

3/ Dispositif selon la revendication 2, caractérisé par le fait qu'un seul dit générateur laser (1) forme un faisceau initial (40) dont une fraction majoritaire forme ledit faisceau de travail non focalisé (45) et dont une fraction minoritaire forme ledit faisceau de pilotage non focalisé (46).

4/ Dispositif selon la revendication 2, caractérisé par le fait que lesdites directions de profondeur de travail et de pilotage sont une même direction de profondeur (22) et lesdits moyens de balayage (14, 15, 16) appliquent les mêmes déplacement de balayage auxdites pièces de travail (65) et de modèle (66).

5/ Dispositif selon la revendication 4, caractérisé par le fait que lesdits moyens de balayage (14, 15, 16) portent les deux dites pièces à usiner (65) et de modèle (66) sur une même platine porte pièces (15).

6/ Dispositif selon la revendication 3, caractérisé par le fait que lesdits faisceaux de travail et de pilotage non focalisés sont des faisceaux parallèles et sont parallèles à ladite direction de profondeur,

- lesdits moyens de focalisation de travail et de pilotage étant des lentilles de travail (5) et de pilotage (6),

- lesdits moyens de réglage de profondeur de travail et de pilotage (20) étant des moyens pour déplacer lesdites lentilles de travail et de pilotage, respectivement, selon ladite direction de profondeur.

7/ Dispositif selon la revendication 2, caractérisé par le fait que lesdits faisceaux de travail sont constitués d'une lumière ultraviolette.

8/ Dispositif selon la revendication 7, ladite face de travail (25) de ladite pièce a usiner (65) étant constituée d'un matériau céramique.

9/ Dispositif selon la revendication 2, caractérisé par le fait qu'il comporte des moyens de commande de vitesse (18) pour faire varier la vitesse desdits déplacements de balayage en fonction de paramètres de travail.

EP 0 387 741 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | US-A-3739088 (THE PERKIN-ELMER CORPORATION) <br> * colonne 4, ligne 51 - colonne 5, ligne 48; figure 2 * <br> --- | 1, 2 | B23K26/08 <br> B23Q35/128 |
| A | US-A-3701880 (WESTINGHOUSE ELECTRIC CORPORATION) <br> * le document en entier * <br> ----- | 1, 2 | |

**DOMAINES TECHNIQUES RECHERCHES (Int. Cl.5 )**

B23K
B23Q

Le présent rapport a été établi pour toutes les revendications

| Lieu de la recherche | Date d'achèvement de la recherche | Examinateur |
|---|---|---|
| LA HAYE | 22 JUIN 1990 | ARAN D.D. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

                                        
& : membre de la même famille, document correspondant

EPO FORM 1503 03.82 (P0402)